# EUROPEAN PATENT APPLICATION

(11) **EP 4 765 195 A1**
(43) Date of publication of application: **24.06.2026**
(21) Application number: 24220431.1
(22) Date of filing: 17.12.2024
(51) Int. Cl.: H01L 21/67, H01L 21/677

(54) **BONDING SYSTEMS AND METHODS**

(71) Applicant: ASML Netherlands B.V., 5500 AH Veldhoven (NL)
(72) Inventor: HSU, Chia-Hao, 5500 AH Veldhoven (NL)
(74) Representative: ASML Netherlands B.V.

(57) **Abstract**

In the present invention, an apparatus for transferring dies for bonding to a substrate, the apparatus comprising: at least a first support structure and a second support structure, wherein each support structure is configured to support a substrate for holding at least one die; a first compartment within the apparatus for metrology; a second compartment within the apparatus for transferring the at least one die from the substrate to a die support configured to hold the at least one die, wherein the first and second support structures are separately controllable and movable between the first and second compartments.

## Description

### TECHNICAL FIELD

This description relates to semiconductor bonding systems and methods.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, joined, or otherwise coupled (e.g., to heterogeneous or homogeneous devices) at various points in the fabrication process. The integration of different substrates, circuits, or other patterned devices may rely upon joining of specific portions (for example, conductive contact elements) of multiple die-where these specific portions which may be aligned in three-dimensional space to ensure functional connectivity. As the physical sizes of IC components continue to shrink, and their structures continue to become more complex, accuracy, minimization of distortion and variability, and throughput in coupling become more important. In the context of semiconductor manufacture, improvements in substrate placement and joining lead to improvements in IC manufacturing and integration abilities.

Although stacking the die on substrate is beneficial in increasing functionality, there are improvements to be made in bonding with high speed whilst placing the dies with high accuracy to meet desired electrical performance.

### SUMMARY

According to an embodiment of the present invention, an apparatus is provided for transferring dies for bonding to a substrate, the apparatus comprising: at least a first support structure and a second support structure, wherein each support structure is configured to support a substrate for holding at least one die; a first compartment within the apparatus for metrology; a second compartment within the apparatus for transferring the at least one die from the substrate to a die support configured to hold the at least one die, wherein the first and second support structures are separately controllable and movable between the first and second compartments.

According to an embodiment of the present invention, an apparatus is provided for bonding at least one die to a substrate, the apparatus comprising: at least a first support structure configured to support a first substrate on a first support surface, wherein the substrate is for holding a plurality of dies; and a die structure configured to support the plurality of dies on a die support surface, the die structure being separately controllable from the first support structure, wherein the die support surface is facing the first support surface, and wherein the apparatus is configured to transfer the plurality of dies from the substrate on the first support surface to the die support surface and is configured to move the die structure and to bond the plurality of dies simultaneously from the die structure to a second substrate.

According to an embodiment of the present invention, a method is provided of transferring at least one die from a first substrate to a second substrate using an apparatus comprising a first support structure for supporting a first substrate and a second support structure for supporting a second substrate, the method comprising: performing, in a first compartment within an apparatus, at least one metrology measurement on the first substrate and/or the least one die on the first substrate; moving the first support structure to a second compartment within the apparatus; loading the second substrate onto the second support structure; performing, in the first compartment, at least one metrology measurement on the second substrate and simultaneously transferring, in the second compartment, at least one die from the first substrate to a die support.

According to an embodiment of the present invention, a method is provided of providing an apparatus comprising a first support structure supporting a first substrate for holding at least one die and a second support structure for supporting a second substrate for holding at least one die, the method comprising moving at least the first support structure and the second support structure between a first compartment for metrology and a second compartment for transferring the at least one die from the first substrate, wherein each compartment is within the apparatus and each support structure is separately controllable.

According to an embodiment of the present invention, a method is provided of providing an apparatus comprising a first support structure supporting a first substrate for holding at least one die and a second support structure supporting a second substrate for holding at least one die, the method comprising: performing, in a first compartment within an apparatus, at least one metrology measurement on the second support structure and/or second substrate; and transferring, in a second compartment within the apparatus, at least one die from the first substrate to a die support, wherein the transferring and performing the measurement are carried out simultaneously.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment;
Figures 2, 3, 4, 6, 7 and 8 are schematic diagrams of an embodiment of the invention in which various stages of operation are carried out;
Figure 5 is a schematic diagram of a die transfer device for use in an embodiment of the invention; and
Figure 9 is a block diagram of an example computer system, according to an embodiment of the present disclosure.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer"-that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

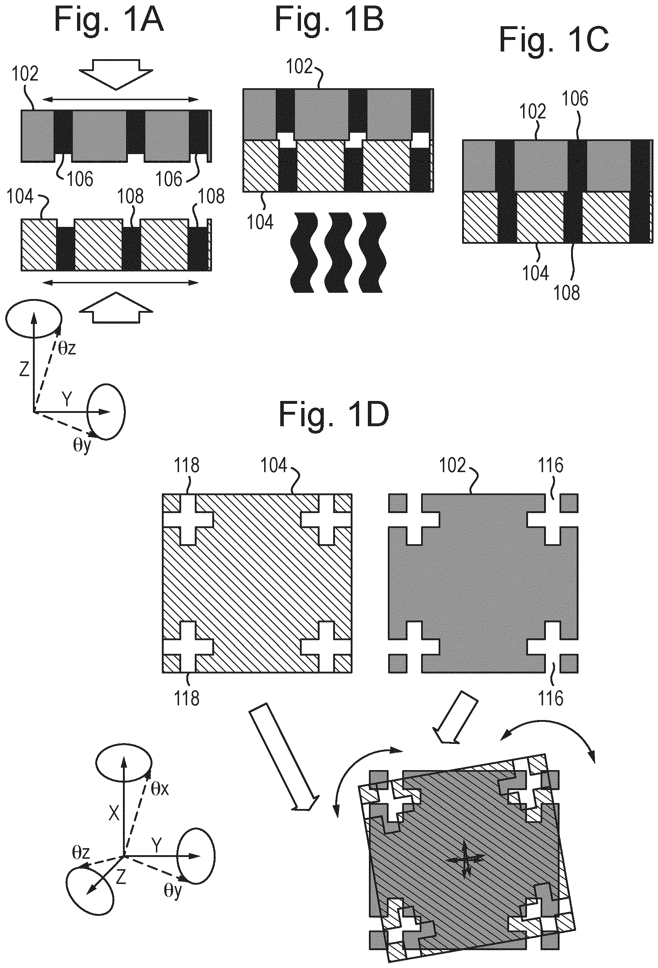

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106. The target die 104 may instead be a target location (which may or may not correspond to areas intended to later become dies) in an undiced wafer, for example. Thus, the target location may be a specific part of a wafer, which may be referred to as an acceptor wafer.

As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach). As shown in Figure 1B, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ-for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method-for example, scribing and breaking, mechanical sawing, laser cutting, etc.-and may destroy (e.g., grind to powder or otherwise render inoperable for circuitry placement) a non-zero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes-e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

Although various techniques and apparatus for bonding at least one die to a substrate are known, existing die-to-substrate bonding may use one bond head to pick up dies sequentially, while another head may perform the same operation independently. An example of a known apparatus with a single bond head carries out sequential steps, wherein a "flipper" is used to pass a die from a donor substrate to a bond head module, metrology steps are then carried out on the die held on the bond head, the bond head is moved to a desired location and the die is bonded to an acceptor substrate. The process is then repeated for the next die, and so on until every die is bonded to the acceptor substrate. Such technologies may bond multiple dies by one bond head by sequentially picking up the dies and then place the dies sequentially onto the desired locations. There are improvements to be made in increasing throughput whilst maintaining high accuracy in placement of the dies at the relevant location.

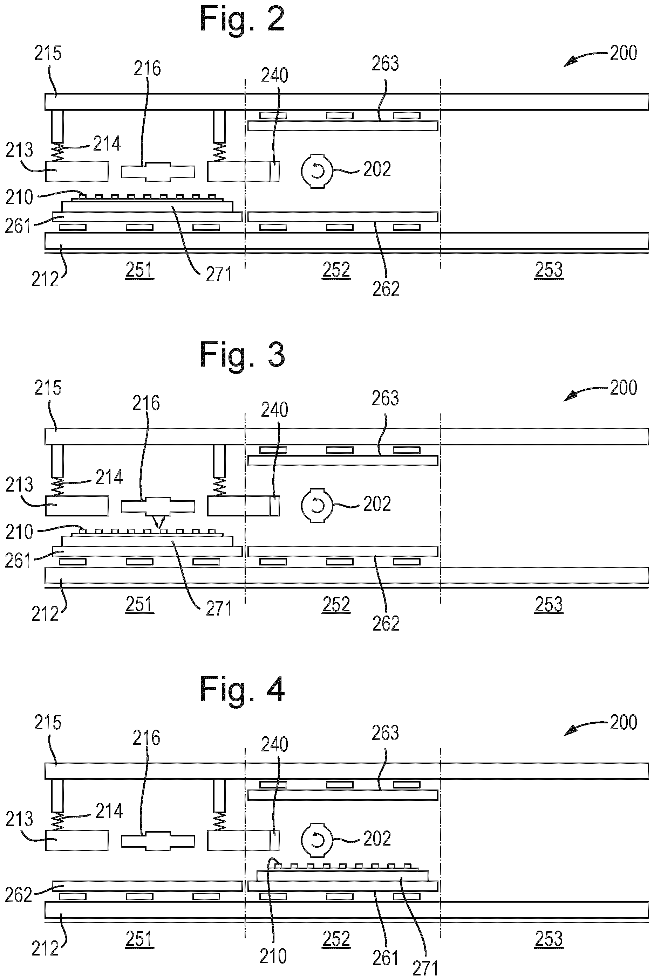

In an embodiment of the present invention, an apparatus is provided for transferring dies for bonding to a substrate. The apparatus is configured to transfer a plurality of dies. The apparatus may be configured to bond the plurality of dies to the substrate. An exemplary embodiment of the apparatus 200 is shown in figures 2-8.

In the present embodiment, the plurality of dies 210, which may be referred to as "donor dies", may be provided on at least one substrate, which may be referred to as a "carrier substrate". The carrier substrate is used to transfer the plurality of dies prior to bonding. The dies can be transferred and moved within the apparatus 200 from the carrier substrate. The apparatus 200 may be configured to bond each of the plurality of dies on a further substrate, which may be referred to as an "acceptor substrate". As each of the dies 210 needs to be placed in a specific location on the acceptor substrate, measurement of the position of the dies 210 when loaded into the apparatus 200 and transferred through the apparatus 200 is important. In order to provide the level of accuracy needed for stacking dies, it is important to provide accurate measurements relevant for placement of each die 210 on the substrate.

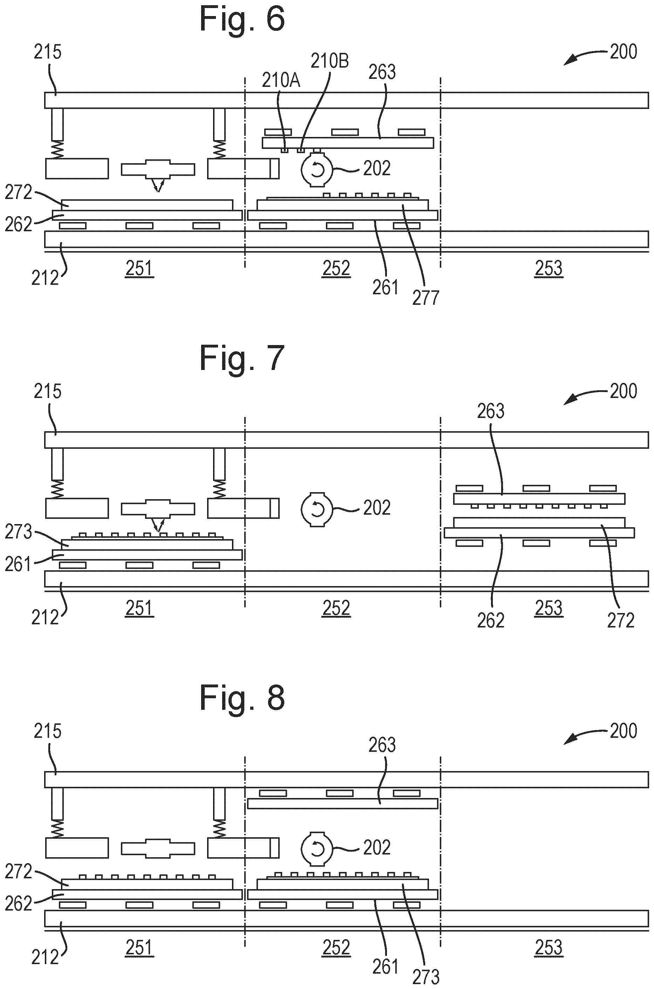

When at least one die 210 is bonded on the acceptor substrate, the combination of the bonded die and acceptor substrate may be referred to as a "bonded substrate" (e.g. the second substrate 272 in figure 8). Further measurements may be taken of the bonded substrate, which can be used to feedback in to the system. Additionally, further dies may be bonded to the bonded substrate, in which case, the bonded substrate can pass through the apparatus 200 again, and may begin the process again as an "acceptor substrate". Thus, the acceptor substrate may be a substrate without any dies bonded to it, or could be a substrate to which at least one die or a plurality of dies has already been bonded.

The apparatus 200 may comprise several compartments. The compartments within the apparatus 200 may be separate, distinct zones within the apparatus 200 in which a specific function is carried out. The compartments may all be connected. As will be clear from the description below, different parts of the apparatus 200 may move freely between the different compartments. The compartments may other be referred to as zones or stations. Each compartment is separate from other compartments in that the compartments form a defined space which does not overlap with other compartments.

The apparatus 200 may comprise at least a first compartment 251 within the apparatus 200 for metrology. The first compartment 251 may be a main area for metrology within the apparatus 200, in particular for making measurements to determine the level and/or alignment of the dies and/or the relevant substrates when loaded into the apparatus 200. Thus, the function carried out in the first compartment relates to measurements of dies and/or substrates which are to be transferred and/or bonded. It will be noted that measurements may be carried out in other parts of the apparatus, i.e. in further compartments, for example, to determine the position of components of the apparatus during further functions.

It is noted that the apparatus 200 may comprise a mechanism by which substrates are loaded into the apparatus 200, and particularly, into the first compartment 251. Any appropriate mechanism may be used. For example, the mechanism may be a substrate handle arm configured to place a substrate (which may or may not have dies already positioned on a surface) on a support structure in the first compartment 251. Substrates may be removed from the first compartment 251, and optionally from the apparatus 200 as a whole, via the same (or a different) mechanism. Thus, substrates may be unloaded from the first compartment 251 via the same path that they are loaded into the first compartment 251.

The apparatus 200 may comprise at least one support structure configured to support a substrate. The at least one support structure may comprise any appropriate clamping mechanism for keeping the substrate in position on the support structure.

As described further below, measurements can be carried out in the first compartment 251 to determine at least one property of the component held in the first compartment 251. For example, the apparatus 200 may carry out alignment measurements of relative components, for example, at least one of the position of a die 210 relative to a carrier substrate, the position of a carrier substrate relative to a support structure, and/or the position of an acceptor substrate relative to a support structure. The measurements may include not only position, but also orientation, for example orientation of a die 210 relative to a carrier substrate and/or orientation of a carrier substrate relative support structure. This is beneficial because if the position of a component on a support structure is known, the position of the support structure can be measured/monitored as the support structure is moved throughout the apparatus 200, and from this, the position of the component can be determined. For example, the apparatus 200 may carry out level measurements of components, for example, the height of at least one of a die 210, a carrier substrate, an acceptor substrate, and/or a bonded substrate.

The first compartment 251 comprises at least one sensor. The at least one sensor may comprise or be an alignment sensor and/or a level sensor and/or an overlay measurement sensor.

The apparatus 200 may comprise a metrology frame 213 positioned in the first compartment 251. The metrology frame 213 may be referred to as an isolated frame. The metrology frame 213 may be isolated relative to the base frame 212 and the upper frame 215, as both frames 212 and 215 are typically subject to (reaction) forces generated by the various actuators used in the apparatus 200 and consequently may transmit undesired vibrations to the metrology frame 213. The bonding tool may comprise an isolator 214. The isolator 214 may be configured to substantially isolate the metrology frame 213 from the upper frame 215. By isolating the metrology frame 213 from the upper frame 215, vibrations of the upper frame 215 may have less of an effect on the metrology frame 213. Although the metrology frame 213 is shown as being connected, albeit via the isolator 214, to the upper frame 215, the metrology frame could additionally or alternatively be connected to the base frame 212.

The metrology frame 213 may comprise the at least one sensor, e.g. 216, configured to perform one or more of the metrology measurements. Thus, the metrology frame may be configured to support or hold at least one sensor 216, which may be fixed to the metrology frame 213. The metrology frame 213 may be configured to provide dual side alignment and levelling, for example, may provide a sensor for measuring at least one property above the metrology frame 213 and below the metrology frame 213.

In an embodiment, a first substrate 271 may be loaded into the apparatus 200 onto a first support structure 261. The first substrate 271 may be loaded onto a first support structure 261 in the first compartment 251. Thus, the first support structure 261 may be used to support the first substrate 271. In this case, the first substrate 271 may be a carrier substrate on which the plurality of dies are provided prior to bonding.

Thus, a first substrate 271 on which a plurality of dies are positioned can be introduced into the first compartment 251, measurements can be taken for determining the position of each of the dies, and the first substrate 271 can then be moved through the apparatus 200 to another compartment.

The apparatus 200 may comprise a second compartment 252 within the apparatus 200 for transferring at least one die 210 from the first substrate 271 to a die support configured to hold the at least one die 210. Providing a second compartment 252 for transferring in addition to a first compartment 251 for metrology is beneficial in that it allows for operations to be carried out in each compartment separately, and simultaneously. This means that when the relevant measurements have been carried out on the first substrate 271, the first substrate 271 can be moved to the second compartment 252 which means that the first compartment 251 is available for carrying out measurements on another component. Thus, a second substrate 272, such as an acceptor substrate, can be loaded into the first compartment 251. The second compartment 252 can then be used for transferring the dies 210 from the first substrate 271 (the carrier substrate) whilst measurements are carried out on the second substrate 272 (the acceptor substrate). It is noted that the acceptor substrate may or may not comprise at least one die 210 already bonded to the surface. Thus more generally, the apparatus 200 is configured to carry out metrology measurements on at least one die 210 and/or substrate holding the at least one die 210 whilst also transferring dies simultaneously.

The apparatus 200 may comprise multiple support structures. This is beneficial in allowing each support structure to support a die and/or substrate, and to move that die and/or substrate throughout the apparatus 200. This means that when measurements have been carried out to determine the position of a component (i.e. the die and/or substrate) on the corresponding support structure, as long as the die and/or substrate is not moved relative to the support structure, the position of the die and/or substrate can be determined from measuring the position of the support structure.

Each support structure is configured to support the die and/or substrate on a support surface. The support surface is configured to hold/contact/support at least one die and/or substrate.

The first and second support structures may be moveable between at least the first and second compartments. The first and second support structures are separately controllable and movable between the first and second compartments. In other words, the support structures can be moved independently of each other between the first and second compartments. The support structures are separate in that they are not directly attached and so can be moved relative to one another in any direction as needed (e.g. in the X/Y/Z direction as shown or in any rotational direction as needed). Providing support structures which are separately controllable and movable between at least the first and second compartments provides freedom in controlling the movement of the support structures, and the substrates on them, throughout the apparatus 200. This means that the substrates can be processed in a way which increases throughput, and preferably, optimizes the way in which substrates can be processed (comprising measurement, transferring and bonding) in the apparatus 200. Preferably, the support structures can be moved (independently of each other) to further compartments also.

Preferably, each of the support structures (including any further support structures) are separately controllable and movable between each of the compartments (including any further compartments).

The first substrate 271 can be moved to the second compartment 252 on the first support structure 261. This provides space in the first support structure 261 in which a second support structure 262 can be positioned. Thus, when the second substrate 272 is introduced into the apparatus 200, it can be supported on the second support structure 262. Measurements can then be carried out on the second substrate 272.

Meanwhile, at least one die 210 can be transferred from the first substrate 271 (the carrier substrate). The at least one die 210 can be transferred to the die support. The die support may be a die structure 263 configured to support the at least one die 210 on a die support surface, the die structure 263 being separately controllable from any other support structure, e.g. from the first and second support structures. The die structure 263 may be separately controllable and moveable from the other support structures, namely the first and second support structure 262.

Each die may be transferred from the first substrate 271 to the die support which may be a part of the apparatus 200. Each die may be transferred by a die transfer device from the first substrate 271 to the die structure 263. Each die may be transferred directly from the first substrate 271 to the die transfer device to the die structure 263 without being placed or positioned on any other components. The die support may be die support structure. The die support structure may be similar in configuration to the first and/or second support structures. Thus, the die support structure may provide carrier-less die transfer (i.e. without being positioned on a substrate on the die support structure). This can be beneficial for collective die wafer bonding - such that the dies can all be transferred to the die support structure and can be bonded in one go (i.e. substantially simultaneously) onto an acceptor substrate.

The die support structure may be an upper support structure. The other support structures, for example the first and second support structures, may be lower support structures. Thus, the dies support structure may be above the first and second support structures and may have a die support surface, on which the at least one die can be supported, facing towards the first and/or second support structure. When the first support structure 261 is positioned in the second compartment 252, the die support surface may be facing a first support surface of the first support structure 261. In this embodiment, the apparatus 200 is configured to transfer a plurality of dies from the substrate on the first support surface to the die support surface.

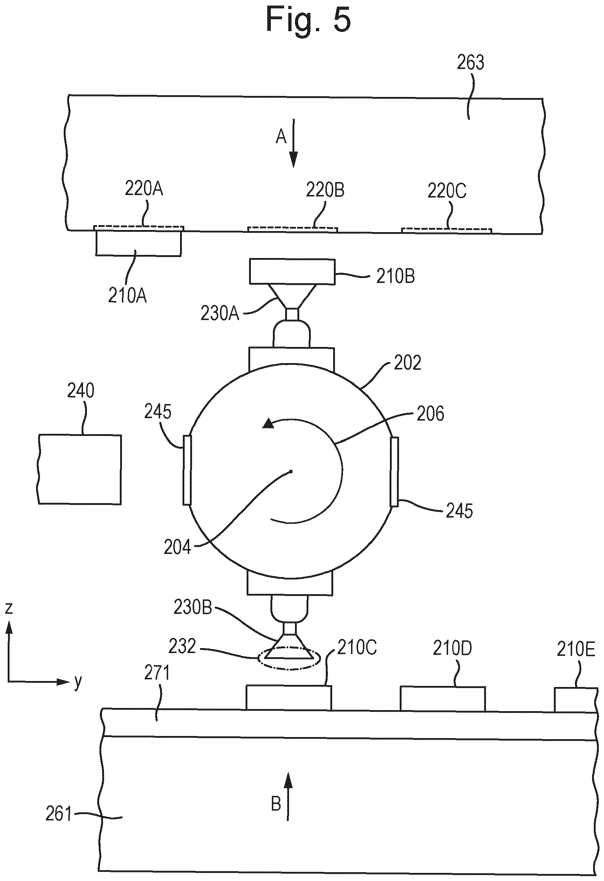

Figure 5 is a schematic diagram illustrating a die transfer device for picking up and placing dies using movable support structures. Figure 5 is a cross-sectional view of the die transfer device during pick up and placement of at least one die 210A-210E on the die support structure.

The die transfer device comprises a support stage 202. The support stage 202 is substantially circular in the z-y plane, with a longitudinal axis 204 along the x-direction (e.g., the support stage 202 is substantially cylindrical in three dimensions). The support stage 202 may instead have a different cross-sectional shape, such as square, hexagonal, etc. The support stage 202 may have a symmetrical (e.g., as shown) cross-section with one or more axis of symmetry, or asymmetrical cross-sectional area (for example, an irregular polygon).

The support stage 202 may be controllably moved in a direction 206 about the longitudinal axis 204. Thus, the support stage 202 may be referred to as a rotating bond head configured to rotate about the longitudinal axis 204. The direction 206 is provided as an example. The support stage 202 may instead be rotated in an opposite direction. Preferably, the support stage may be fixed in the translational direction to move only in the rotational direction. Thus, the longitudinal axis 204 may be substantially fixed. The support stage 202 may move continuously or intermittently. For example, the support stage 202 may rotate in the direction 206 and stop at four (or fewer or more) positions corresponding to operations in the placement of die.

The support stage 202 comprises at least one acceptor portion 230 (which may otherwise be referred to as an arrow head). Preferably, the support stage comprises multiple acceptor portions 230, preferably at least two acceptor portions 230. Each acceptor portion 230 is configured to support a die. Each acceptor portion 230 may be configured to support a single die 210, e.g. one of 210A-210E.

The placement of the acceptor portion 230 may be symmetrical or asymmetrical around the cross-sectional area of the support stage 202. The support stage 202 may have a substantially symmetrical cross section but have asymmetric placement of recesses. For example, the support stage 202 may have a cross-section that is a regular hexagon but have recesses placed asymmetrically along longitudinal faces.

The die transfer device may comprise two acceptor portions 230 positioned on opposite sides of the rotating bond head, for example as shown in figure 5.

Each acceptor portion 230 may adhere an end effector (such as a conical suction end effector indicated by the dashed ellipse 232) to one or more surfaces of the die 210B. The acceptor portion 230 may otherwise be referred to as a pick and place element, or a nozzle. Other end effector configurations and methods of die placement may be used, such as clamping, hydraulic, electrostatic, capacitive, and other types of adhesion. Thus, instead of a conical suction end effector, an electrostatic or vacuum clamp may be used. The acceptor portion 230 may move the die from a pick up location (for example, a chip storage location on the carrier substrate) to a release location, which may be a target location on the die support structure 263. The acceptor portion 230 may move the die in one or more direction. The acceptor portion 230 may be a chip shooter. The acceptor portion 230 may adhere to the die electrostatically, through use of suction, via hydraulic effects, through capacitive attraction, etc. The acceptor portion 230 may interact with the die via an end effector, which may controllably hold and release the die.

As the acceptor portion 230 (which may otherwise be referred to as a nozzle) can be used to pick up and place a die (of any size), the size of the acceptor portion 230 is preferably independent of the die size. This acceptor portion 230 may accommodate any size of die because it is only used to transfer the die, and so only needs to provide enough force to pick up the die. This is beneficial in providing design freedom and means that swapping of the acceptor portion for dies of different sizes is not needed. Thus, one acceptor portion 230 (e.g. one pick-up and place-down head) can be used for all kind of applications, e.g. for different sized dies. For example only, a diameter of the acceptor portion 230 may be between approximately 1 mm and 10 mm.

The apparatus 200 may be configured to pick up a die and place a die substantially simultaneously. Thus, the apparatus 200 may be configured to pick up one die on an acceptor portion 230 (e.g. 230B in figure 5) and put down a further die from a further acceptor portion 230 (e.g. 230A in Figure 5) substantially simultaneously. In other words, the apparatus 200 may be configured to pick up one die 210C on an acceptor portion 230 (e.g. 230B in figure 5) from the first substrate 271 (i.e. a carrier die) and, substantially simultaneously, place a further die 210B from a further acceptor portion 230 (e.g. 230A in Figure 5) to the die structure 263.

Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc.. These positions and operations are described as happening in discrete positions (such as when movement of the support stage 202 is substantially zero), but the positions may instead correspond to continuous (or quasi-continuous movement) or operations may occur while the support stage 202 is moving in at least one direction (e.g., rotationally, etc.).

In general, the die transfer device, and more particularly the support stage 202 may be fixed and other components of the apparatus 200 may be moved relative to the support stage 202. For example, the die support structure may be configured to move translationally relative to the support stage. Similarly, the first and/or second support structure may be configured to move translationally relative to the support stage 202. In this way, a die supported (generally indirectly on a substrate such as the carrier substrate) can be moved into contact with the acceptor portion 230 so that the acceptor portion 230 can pick up the die. Similarly, the die support structure can be brought into contact with the die held by the die transfer device so that the acceptor portion 230 can release the die onto the die support structure.

A first position of the die transfer device is depicted in figure 5. In figure 5, transfer of at least one die has occurred and further dies are in the process of being moved from the first substrate 271 (i.e. a carrier die) as described above.

In the position shown, a first die 210A has already been placed on the die support structure. As shown, the first die 210A is positioned on a target location 220A on the surface of the die support structure. A first acceptor portion 230A has been used to pick up a second die 210B from a surface of the carrier substrate (e.g. first substrate 271). The apparatus 200 can be used to place the second die 210B on the die support structure at substantially the same time as picking up a further die, a third die 210C, from the first substrate 271.

The second die 210B can be placed on a corresponding target location, i.e. a second target location 220B, of the die support structure. The second die 210B can be placed by moving the die support structure in the direction of arrow A, i.e. towards the die transfer device, and particularly towards the first acceptor portion 230A of the support stage 202 holding the second die 210B. As the die support structure shown is provided above the die transfer device (in the Z direction shown), the direction of arrow A is downwards, i.e. parallel to the z direction.

The first acceptor portion 230A may place the die 210B on the die support structure at a given position relative to the second target location 220B. For example, the first acceptor portion 230A may center the die 210B on the second target location 220B. The first acceptor portion 230A may place the die 210B on the die support structure based on alignment information (for example, based on detection of the position of the die support structure preferably in combination with feedback correction information obtained from prior bonded wafer), based on positional information of the support stage 202 (for example, based on detection that the support stage 202 is at the first position), etc. Placement of the die 210B may have intrinsic error or inaccuracy. When the die support structure is brought into contact with the die 210B held by the die transfer device and the acceptor portion 230A releases the die onto the die support structure, the die 210B adheres to the surface of the die support structure (e.g. due to at least an attractive force between the die 210 and the surface of the die support, for example due to adhesive, vacuum, electrostatic force, etc.).

The third die 210C can be picked up from the first substrate 271 by moving the first substrate 271 in the direction of arrow B, i.e. towards the die transfer device, and particularly towards a second acceptor portion 230B of the support stage 202 for holding the third die 210C. As the first substrate 271/first support structure 261 shown is provided below the die transfer device (in the Z direction shown), the direction of arrow B is upwards, i.e. parallel to the z direction.

The position (e.g., location) of the support state 202 may be measured by a location measurement element 240. The position of a die on the support stage 202 may be determined based on the measured position of the support stage 202 and the measured position of the first support structure 261 (i.e. the support structure carrying the substrate on which the die is provided) as the relative position between the die and the support structure would be known, e.g. based on the measurements carried out in the metrology compartment.

The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the x-z plane (relative to the refence axes) and an out of plane measurement device which may measure locations or distances in the y direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 202. The location measurement element 240 may measure the position of the support stage 202 using a marker 245 on the support stage 202 when the support stage 202 is moved between the first and second positions.

When the second die 210B has been placed and the third die 210C has been picked up, the support stage 202 may move (e.g. in direction 206), so that the third die 210C occupies the position of the second donor die 210B in figure 5. In this position, the third die 210C can be placed on the corresponding target portion 220C on the die support structure, and a further die 210D can be picked up from the first substrate 271. The die transfer device can be used to pick up and place multiple dies through subsequent pick up and place operations, e.g. to pick up a fifth die 210E and so on, until all (or a selected number) of dies provided on a first substrate 271 have been transferred to the die support structure.

In the present embodiment, the apparatus 200 may be further configured to bond the dies to the second substrate 272 (the acceptor substrate). The apparatus 200 may comprise a third compartment 253 within the apparatus 200 for bonding.

The die structure 263 is movable between at least the second and third compartment 253. Thus, when the dies have been transferred from the first substrate 271 to the die structure 263, the apparatus 200 is configured to move the die structure 263 from the transfer compartment to the third compartment 253 for bonding.

The first and second support structures are moveable between the third compartment 253 and the other compartments.

When the relevant measurements have been carried out on the second substrate 272 (the acceptor substrate) in the first compartment 251, the apparatus 200 is configured to move the second support structure 262 to the third compartment 253 for bonding.

Thus, both the second support structure 262 holding the second substrate 272 and the die support structure holding the dies can be positioned in the third compartment 253. In general, the die structure 263 and at least one of the first and second support structures may be positioned within a single compartment at the same time.

The apparatus 200 is configured to bond the plurality of dies simultaneously from the die structure 263 to a second substrate 272. This may be done by moving at least one of the die support structure and/or the second support structure on which the second substrate 272 is positioned so that the plurality of dies on the die support structure come into contact with the second substrate 272. As the dies are generally brought into contact with the second substrate 272 at substantially the same time, the plurality of dies can be bonded to the substrate substantially simultaneously.

When the dies have been bonded to the second substrate 272, the apparatus 200 may be configured to move the second substrate 272 back to the first compartment 251. Preferably, the apparatus 200 is configured to carry out additional measurements on the bonded dies on the substrate. For example overlay between marks on the donor dies and the marks on the acceptor substrate may be measured. This measurement information may be used to improve subsequent operation of the apparatus 200, e.g. enhance placement accuracy of the donor dies 210 on the acceptor substrate. Alternatively, or additionally absolute position measurement of marks on the bonded substrate may be performed to provide subsequent processing steps, such as lithography, with high quality positional information associated with patterns provided on the donor dies and/or acceptor substrate. In the case of lithography (post-bonding lithography) the lithographic apparatus may then provide further patterns on the bonded substrate with a more accurate reference to the already present patterns on the bonded substrate.

It will be noted that whilst bonding is occurring, another substrate, i.e. a third substrate 273, which may be a further carrier substrate, may be loaded onto the first support structure 261 and measurements may be carried out in the first compartment 251 whilst bonding is carried out in the third compartment 253. Thus, metrology and bonding operations can be carried out simultaneously. After measurements, the third substrate 273 can be moved to the second compartment 252 to transfer dies from the third substrate 273 to the die substrate support (e.g. once all the previous dies have been bonded to the second substrate 272 and the die support structure is returned to the second compartment 252).

The multiple compartments and multiple support structures (e.g. first support structure 261 and/or second support structure 262 and/or die structure 263) are beneficial in that various operations can be carried out simultaneously. This means that various steps for measuring and bonding one set of die to an acceptor wafer can be carried out at the same time. Additionally or alternatively, one loop of measurement, transfer and bonding for one set of dies and an acceptor wafer can overlap with another loop of measurement, transfer and bonding.

In the above described embodiments, each of the structures, e.g. the first support structure 261, the second support structure 262 and the die structure 263 are moveable. The apparatus 200 may comprise a positioning device for each structure, i.e. a first positioning device for the first support structure 261, a second positioning device for the second support structure 262, and a third positioning device for the die structure 263. Each the positioning device may be configured to move a respective structure between at least two compartments (preferably between each/all of the compartments) and is configured to move said respective structure to a specific location within each of the at least two compartments (preferably between each/all of the compartments).

For example, the first support structure 261 may comprise a long stroke module for relatively coarse positioning of the first support structure 261 over a longer distance, and a short stroke module for higher accuracy positioning of the first support structure 261 over a shorter distance. The short stroke module may be stacked on the long stroke module. The short stroke module and the long stroke module may each be part of a first positioning system configured to position the first support structure 261 (and therefore to position the substrate and/or die supported on the first support structure 261) in the horizontal plane, i.e. in the x- and y-directions. The short stroke module and the long stroke module may each comprise one or more actuators configured to move the first support structure 261 relative to the base frame 212. Thus, in general, the positioning system may comprise one or more actuators configured to move the first support structure 261.

The apparatus 200 may comprise a second positioning system configured to position the second support structure 262 (and therefore to position the substrate and/or die supported on the second support structure 262) in the horizontal plane, i.e. in the x- and y-directions in the same way as the first positioning system.

The apparatus 200 may comprise a third positioning system configured to position the die structure 263 (and therefore to position the substrate and/or die supported on the die structure 263) in the horizontal plane, i.e. in the x- and y-directions in the same way as the first positioning system, except that the short stroke module and the long stroke module may each comprise one or more actuators configured to move the die structure 263 relative to the upper frame 215 (instead of the base frame 212).

Each positioning system may comprise one or more sensors configured to determine the position of the support structure. The one or more sensors may be interferometric sensors, for example as described in US 20050248771 A1, the entirety of which is hereby incorporated by reference.

Each support structure may comprise at least one mark (e.g. a fiducial mark), not shown, so that the position of the support structure can be measured by at least one sensor, such as location measurement element 240 or any other appropriate sensor. Each mark may be measured using the sensors which form part of the positioning system for that support structure.

The apparatus 200 described above can be used for carrying out a method of transferring and optionally bonding dies to a substrate. The method of the present invention may include some of, or all of, the steps described above.

In one embodiment, a method of transferring at least one die from the first substrate 271 to the second substrate 272 is provided. The method may comprise loading the first substrate 271 onto the first support structure 261 (as shown in figure 2). The method comprises performing, in the first compartment 251, at least one metrology measurement on the first substrate 271 and/or the least one die on the first substrate 271 (as shown in figure 3). The method comprises moving the first support structure 261 to the second compartment 252 (as shown in figure 4). The method comprises loading the second substrate 272 onto the second support structure 262 (as shown in figure 6). As will be understood, as the first support structure 261 is moved to the second compartment 252, the second support structure 262 can be provided in the first compartment 251. The method comprises performing, in the first compartment 251, at least one metrology measurement on the second substrate 272 and simultaneously transferring, in the second compartment 252, at least one die from the first substrate 271 to a die support (as shown in figure 6). The method may further comprise moving the die support and the second support structure 262 to the third compartment 253 and bonding the at least one die on the die support to the second substrate 272 in the third compartment 253 (as shown in figure 7). The method may further comprise unloading the first substrate 271 from the first support structure 261 and loading a third substrate 273 comprising at least one die onto the first support structure 261 (as shown in figure 7). The third substrate 273 may be loaded onto the first support structure 261 at the same time as, i.e. simultaneous to the bonding of the dies on the second substrate 272. The method may further comprise performing, in the first compartment 251, at least one metrology measurement on the third substrate 273 and/or at least one die on the third substrate 273, wherein the measurement and the bonding are carried out simultaneously (as shown in figure 7). The method may comprise carrying out at least one metrology measurement of the at least one bonded die on the second substrate 272 (as shown in figure 8). The measurements on the bonded second substrate 272 may be carried out at the same time as the third substrate 273 is moved to the second compartment 252 and/or at the same time that dies on the third substrate 273 are transferred to the die structure 263. The method may further comprise determining any error in die placement of the at least one bonded die on the second substrate 272, and adjusting the apparatus 200 to account for the error in further movement and/or transferring steps. Thus, the method and apparatus 200 allows for feedback from the most recently bonded substrate to be quickly utilised for the next bonding process.

In an embodiment, a method comprises providing an apparatus 200 comprising the first support structure 261 supporting the first substrate 271 for holding at least one die and the second support structure 262 for supporting the second substrate 272 for holding at least one die. The method comprises moving at least the first support structure 261 and the second support structure 262 between the first compartment 251 for metrology and the second compartment 252 for transferring the at least one die from the first substrate 271, wherein each compartment is within the apparatus 200 and each support structure is separately controllable.

In an embodiment, a method comprises providing an apparatus 200 comprising the first support structure 261 supporting the first substrate 271 for holding at least one die and the second support structure 262 supporting the second substrate 272 for holding at least one die, the method comprising: (a) performing, in the first compartment 251, at least one metrology measurement on the second support structure 262 and/or second substrate 272; and (b) transferring, in the second compartment 252 within the apparatus 200, at least one die from the first substrate 271 to a die support, wherein the transferring and performing the measurement are carried out simultaneously.

In the above embodiments, various operations are described as being carried out simultaneously. It will be understood that this means that the operations as a whole are to be carried out at generally the same time, e.g. ongoing measurements may be carried out throughout the transferring of dies, and/or ongoing transfer of dies may be carried out at the same time as steps are taken to implement bonding. Thus, the steps of different procedures can be carried out at the same time, and it is not required that specific steps within each of these procedures are carried out at the exact second, millisecond or nanosecond etc that a step in another procedure is being carried out.

Although in above embodiments, the die is transferred directly on to the die support, there is an alternative in which the die is transferred onto a further substrate, e.g. a carrier or acceptor substrate. The carrier or acceptor substrate can be held by the die support structure.

Although in the above description, the transfer device is a rotating transfer head, other variations of transfer device comprising at least one acceptor portion 230 configured to support the at least one die could be used.

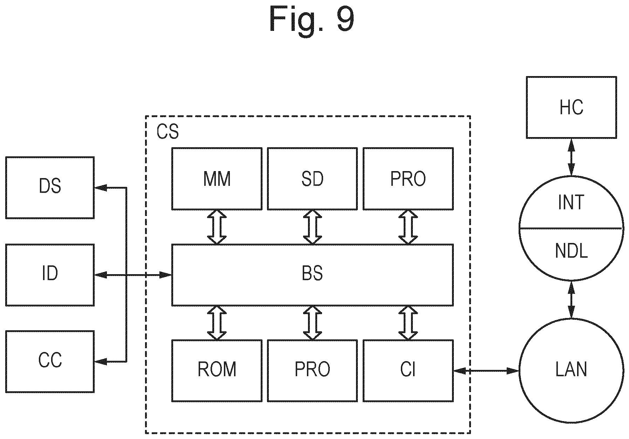

Figure 9 is a diagram of an example computer system CS that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope.

Embodiments of the disclosure are defined in the following numbered clauses:
1. An apparatus for transferring dies for bonding to a substrate, the apparatus comprising:
   at least a first support structure and a second support structure, wherein each support structure is configured to support a substrate for holding at least one die;
   a first compartment within the apparatus for metrology;
   a second compartment within the apparatus for transferring the at least one die from the substrate to a die support configured to hold the at least one die,
   wherein the first and second support structures are separately controllable and movable between the first and second compartments.
2. The apparatus of clause 1, wherein the die support is a die structure configured to support the at least one die on a die support surface, the die structure being separately controllable from the first and second support structures.
3. The apparatus of clause 2, wherein the first support structure is configured to support the substrate on a first support surface, wherein the die support surface is facing the first support surface, and wherein the apparatus is configured to transfer a plurality of dies from the first support surface to the die support surface and is configured to move the die structure and to bond the plurality of dies simultaneously from the die structure to a second substrate.
4. An apparatus for bonding at least one die to a substrate, the apparatus comprising:
   at least a first support structure configured to support a first substrate on a first support surface, wherein the substrate is for holding a plurality of dies; and
   a die structure configured to support the plurality of dies on a die support surface, the die structure being separately controllable from the first support structure, wherein the die support surface is facing the first support surface, and
   wherein the apparatus is configured to transfer the plurality of dies from the substrate on the first support surface to the die support surface and is configured to move the die structure and to bond the plurality of dies simultaneously from the die structure to a second substrate.
5. The apparatus of clause 4, further comprising a second support structure configured to support a substrate for holding at least one die, wherein each support structure is separately controllable.
6. The apparatus of clause 5, further comprising:
   a first compartment within the apparatus for metrology;
   a second compartment within the apparatus for transferring the at least one die from the substrate to the die structure,
   wherein the first and second support structures are movable between the first and second compartments.
7. The apparatus of any one of clauses 1-3 or 6, wherein the apparatus is configured to carry out metrology measurements on the least one die and/or substrate holding the at least one die and transferring of the at least one donor dies simultaneously.
8. The apparatus of any one of clauses 1-3, 6 or 7, wherein the apparatus comprises a metrology frame positioned in the first compartment, the metrology frame comprising at least one sensor configured to perform one or more of the metrology measurements.
9. The apparatus of clause 8, wherein the at least one sensor comprises an alignment sensor and/or a level sensor and/or an overlay measurement sensor.
10. The apparatus of any one of the preceding clauses, further comprising a compartment within the apparatus for bonding.
11. The apparatus of any one of the preceding clauses, wherein the die structure and at least one of the first and second support structures can be positioned within a single compartment at the same time.
12. The apparatus of any one of the preceding clauses, further comprising a die transfer device comprising at least one acceptor portion configured to support the at least one die.
13. The apparatus of clause 12, wherein the at least one acceptor portion comprises an electrostatic or vacuum clamp.
14. The apparatus of either one of clauses 12 or 13, wherein a diameter of the at least one acceptor portion is between approximately 1 mm and 10 mm.
15. The apparatus of any one of clauses 12 to 14, wherein the die transfer device comprises a rotating bond head configured to rotate about a longitudinal axis.
16. The apparatus of clause 15, wherein the die transfer device comprises at least two acceptor portions positioned on the rotating bond head.
17. The apparatus of clause 16, wherein the two acceptor portions are positioned on opposite sides of the rotating bond head.
18. The apparatus of clause 17, wherein the apparatus is configured to position a first die on a first acceptor portion and remove a second die from a second acceptor portion substantially simultaneously.
19. The apparatus of any one of the preceding clauses, further comprising a positioning device for each structure, wherein the positioning device is configured to move said structure between at least two compartments and is configured to move said structure to a specific location within each of the at least two compartments.
20. A method of transferring at least one die from a first substrate to a second substrate using an apparatus comprising a first support structure for supporting a first substrate and a second support structure for supporting a second substrate, the method comprising:
   performing, in a first compartment within an apparatus, at least one metrology measurement on the first substrate and/or the least one die on the first substrate;
   moving the first support structure to a second compartment within the apparatus;
   loading the second substrate onto the second support structure;
   performing, in the first compartment, at least one metrology measurement on the second substrate and simultaneously transferring, in the second compartment, at least one die from the first substrate to a die support.
21. The method of clause 20, further comprising moving the die support and the second support structure to a third compartment within the apparatus and bonding the at least one die on the die support to the second substrate in the third compartment.
22. The method of clause 21, further comprising unloading the first substrate from the first support structure and loading a third substrate comprising at least one die onto the first support structure.
23. The method of clause 22, further comprising performing, in the first compartment, at least one metrology measurement on the third substrate and/or at least one die on the third substrate, wherein the measurement and the bonding are carried out simultaneously.
24. The method of any one of clauses 21 to 23, further comprising carrying out at least one metrology measurement of the at least one bonded die on the second substrate.
25. The method of clause 24, further comprising determining any error in die placement of the at least one bonded die on the second substrate, and adjusting the apparatus to account for the error in further movement and/or transferring steps.
26. A method of providing an apparatus comprising a first support structure supporting a first substrate for holding at least one die and a second support structure for supporting a second substrate for holding at least one die, the method comprising moving at least the first support structure and the second support structure between a first compartment for metrology and a second compartment for transferring the at least one die from the first substrate, wherein each compartment is within the apparatus and each support structure is separately controllable.
27. A method of providing an apparatus comprising a first support structure supporting a first substrate for holding at least one die and a second support structure supporting a second substrate for holding at least one die, the method comprising:
   performing, in a first compartment within an apparatus, at least one metrology measurement on the second support structure and/or second substrate; and
   transferring, in a second compartment within the apparatus, at least one die from the first substrate to a die support, wherein the transferring and performing the measurement are carried out simultaneously.

## Claims

1. An apparatus for transferring dies for bonding to a substrate, the apparatus comprising:
at least a first support structure and a second support structure, wherein each support structure is configured to support a substrate for holding at least one die;
a first compartment within the apparatus for metrology;
a second compartment within the apparatus for transferring the at least one die from the substrate to a die support configured to hold the at least one die,
wherein the first and second support structures are separately controllable and movable between the first and second compartments.

2. The apparatus of claim 1, wherein the die support is a die structure configured to support the at least one die on a die support surface, the die structure being separately controllable from the first and second support structures.

3. The apparatus of claim 2, wherein the first support structure is configured to support the substrate on a first support surface, wherein the die support surface is facing the first support surface, and wherein the apparatus is configured to transfer a plurality of dies from the first support surface to the die support surface and is configured to move the die structure and to bond the plurality of dies simultaneously from the die structure to a second substrate.

4. The apparatus of claim 1, wherein the apparatus is configured to carry out metrology measurements on the least one die and/or substrate holding the at least one die and transferring of the at least one donor dies simultaneously.

5. The apparatus of claim 1, wherein the apparatus comprises a metrology frame positioned in the first compartment, the metrology frame comprising at least one sensor configured to perform one or more of the metrology measurements.

6. The apparatus of claim 5, wherein the at least one sensor comprises an alignment sensor and/or a level sensor and/or an overlay measurement sensor.

7. The apparatus of claim 1, further comprising a compartment within the apparatus for bonding.

8. The apparatus of claim 1, wherein the die structure and at least one of the first and second support structures can be positioned within a single compartment at the same time.

9. The apparatus of claim 1, further comprising a die transfer device comprising at least one acceptor portion configured to support the at least one die.

10. The apparatus of claim 9, wherein the at least one acceptor portion comprises an electrostatic or vacuum clamp.

11. The apparatus of claim 9 or 10, wherein a diameter of the at least one acceptor portion is between approximately 1 mm and 10 mm.

12. The apparatus of claim 9, wherein the die transfer device comprises a rotating bond head configured to rotate about a longitudinal axis.

13. The apparatus of claim 12, wherein the die transfer device comprises at least two acceptor portions positioned on the rotating bond head.

14. The apparatus of claim 12, wherein the two acceptor portions are positioned on opposite sides of the rotating bond head.

15. The apparatus of claim 14, wherein the apparatus is configured to position a first die on a first acceptor portion and remove a second die from a second acceptor portion substantially simultaneously.
